# EUROPEAN PATENT APPLICATION

(11) **EP 4 775 528 A1**
(43) Date of publication of application: **15.07.2026**
(21) Application number: 25170919.2
(22) Date of filing: 16.04.2025
(51) Int. Cl.: B81C 1/00, G02B 6/136

(54) **IMPLEMENTATION OF MICRO- AND NANO-STRUCTURES ON ANISOTROPIC MATERIALS**

(30) Priority: 14.01.2025 SE 2530015
(71) Applicant: LiNPhA AB, 170 75 Solna (SE)
(72) Inventor: PRENCIPE,, Alessandro, 170 75 Solna (SE); FERGESTAD,, Halvor, 115 43 Stockholm (SE)
(74) Representative: Potter Clarkson

(57) **Abstract**

The present disclosure relates to a system for use in a process for implementing a miniaturized structure of an anisotropic material, the system comprising a lithography system for defining an etching mask compatible with the shape of the miniaturized structure, a dry etching system used to define the sidewalls and facts of the miniaturized structure, a chemical etching system used to define the bottom profile of the miniaturized structure. Optionally the etching system may be replaced or complemented by another system capable of dicing, cutting or ablating the anisotropic crystal so to define the sidewalls and facets of the miniaturized structure. The system may comprise also a tool to transfer the miniaturized structure from the bulk wafer where it was structured to a new substrate. The present disclosure further relates to a method for obtaining a micro- or nano-structure starting from a monolithic wafer of an anisotropic material with thickness between several tens of microns and few millimeters.

## Description

The present disclosure relates to a system for use in a process for implementing micro- and nano-structure on an anisotropic material for use in photonic applications. The present disclosure relates also to a method of implementing micro- and nano-structures on an anisotropic material. The present disclosure relates also to micro- and nano-structures fabricated starting from an anisotropic material according to a method of the present disclosure.

### Background

Anisotropic materials are materials presenting physical properties which vary depending on the direction along which they are measured. In anisotropic crystals this means that the material properties are different along different crystallographic axes.

Anisotropic crystals are broadly used in optics, photonics, electronics and acoustics as they are critical to advancing applications across diverse industries including telecommunications, lasing, sensing, metrology, MEMS and quantum technologies. Depending on their nature, anisotropic crystals can be utilized to leverage properties like birefringence, pyroelectricity, piezoelectricity, peculiar acoustic and elasto-optic properties, nonlinear optical properties as well as electro-optic effects.

Devices relying on anisotropic crystals are for example: optical waveplates, acousto-optic modulators, Pockels' cells, surface acoustic wave (SAW)-based sensors and actuators. These devices are typically mm- or cm-sized and, within this disclosure will be referred to as "bulk devices" or "devices in bulk format". Miniaturized versions of bulk devices have been proposed. Such miniaturized versions are typically obtained starting from a thin-film of an anisotropic crystals which is then micro- or nano-structured. The footprint reduction enabled by the thin-film format permits to access new functionalities which in bulk devices are not available or enhance effects that cannot be fully leveraged in devices in bulk format.

Depending on the anisotropic material, different methods could be utilized to implement an anisotropic crystal thin-film. For use in electronics, photonic, acoustics and related fields, it is convenient that such thin-films are available in wafer formats. A wafer constituted of a material stack containing an anisotropic crystal thin-film can be utilized to implement, leveraging micro- and nano-fabrication techniques, micro- and nano-structured devices based on anisotropic crystals.

Different processes based on atomic layer depositions have been proposed to obtain barium titanate, BaTiO3, thin-films. BaTiO3 is an anisotropic ferroelectric crystal. Epitaxial growth can be effective for other anisotropic materials.

In the case of lithium niobate, LiNbO3, an anisotropic ferroelectric crystal, the most common approach to implement a thin-film is the so-called smart-cut method. This consists in starting from a thicker lithium niobate single crystal (obtained, for example, using the Czochralski method) and implanting He+ ions with energies in the range of 100-500 keV to create a defect layer in the crystal. The He-implanted lithium niobate crystal is then bonded onto a carrier wafer and the stack is subsequently annealed and split so to obtain a thin-film of lithium niobate on the carrier wafer. Subsequent annealing processes are often needed to retrieve mono-crystallinity in the lithium niobate thin-film. The good result of the process relates to the uniformity of the He+ ion implantation process. The thickness of the thin-film is set by the depth of implantation of the He+ ions. In the case of LiNbO3, film thicknesses up to around 1*µ*m were demonstrated with high repeatability. For other materials the achievable thickness might vary on the crystal structure.

Leveraging different methods, it is possible to obtain wafer stacks where an anisotropic crystal thin-film sits on top of at least another layer. The at least one other layer provides mechanical stability to the wafer stack. Leveraging different methods, it is possible to obtain wafer stacks containing high quality monocrystalline, anisotropic crystals in thin-film format, suited for micro- and nano-structuring.

In the following of this disclosure, a monocrystalline wafer constituted by a single material and with thickness between 150*µ*m and few millimeters will be referred to as a "bulk wafer".

In the following of this disclosure, a wafer stack containing a layer of a monocrystalline anisotropic crystal with thickness between 10nm and 10 *µ*m sitting on top at least another layer will be referred to as a "thin-film wafer".

The methods required to obtain thin-film wafers need access to expensive cleanroom facilities and dedicated nanofabrication systems. For example a commercially available 4-inch wafer of thin-film lithium niobate obtained by smart-cut method (meaning, for example, a wafer stack containing a sub-micrometric layer of monocrystalline lithium niobate sitting on top of a layer of silicon dioxide, SiO2, with thickness between 2*µ*m and 5*µ*m, again sitting on top of a carrier layer of silicon, Si, with thickness of 500*µ*m) typically costs up to ten times more than a traditional monocrystalline lithium niobate wafer (meaning a monolithic wafer constituted by one material, lithium niobate, with thickness between 200 *µ*m and 2000 *µ*m). High cost, technology complexity and limited number of providers capable of producing high quality thin-film wafers of anisotropic materials are all factor which limits the development of numerous industries within optics, photonics, electronics and related fields which benefit from nanostructured devices on anisotropic materials.

Therefore, an objective of the present disclosure is to provide an improved fabrication system and method to obtain high-quality miniaturized structures starting from a bulk wafer of a monocrystalline anisotropic crystal. The miniaturized structures described in this disclosure are meant for application in photonics. In particular, for electro-optic devices, nonlinear optical devices, and acousto-optic devices implemented on a ferroelectric material.

### Summary

Considering the prior art described in the Background section, it is an objective of the present disclosure to provide a method for obtaining structures with a micrometric or submicrometric cross-section of an anisotropic crystal starting from a bulk wafer of a monocrystalline anisotropic crystal with thickness between several tens microns and few millimeters. In the following the micrometric (submicrometric) structure will be referred to as "the miniaturized structure". For the sake of brevity, the term "structure" is sometimes replacing the term "miniaturized structure", with obvious reference to a miniaturized structure obtained according to this disclosure.

The miniaturised structures of the present disclosure may be, in particular embodiments, high confinement optical structures. Such high confinement optical structures may include waveguides or other structures suitable for use in micro- and nano-scale photonics. In embodiments wherein the miniaturised structures are high confinement optical structures, the present disclosure may allow for the production of high confinement optical structures without the need to use thin film wafers to produce these structures.

The miniaturized structure has a length between 10 *µ*m and few centimeters. The miniaturized structure has a cross-section smaller than 20 *µ*m x 10 *µ*m, for example 600nm x 2 *µ*m.

The miniaturized structure has a **top surface** whose shape can be approximated by a rectangle of area A x B, where A can be between 10 *µ*m and few centimeters and B can be between few hundreds of nm and 20 *µ*m, for example B can be between 500nm and 20 *µ*m. The top surface might be referred to as "top of the miniaturized structure".

**The sidewalls and the facets of the miniaturized structure constitute the profile of the miniaturized structure.** The thickness of the miniaturized structure is between few hundreds of nm and 10 *µ*m. Consequently, the sidewall of a miniaturized structure can be approximated by a rectangle with area A x C, where A can be between 10 *µ*m and few centimeters and C can be between few hundreds of nm and 10 *µ*m. Similarly, the facet of a miniaturized structure, if approximated by a rectangle, has an area of B x C, where B can be between few hundreds of nm and 20 *µ*m and C can be between few hundreds of nm and 10 *µ*m. In one or more embodiments, an unetched upper surface of a pillar that comprises a bottom profile may, in combination with the miniaturised structure, have a sidewall that can be approximated by a rectangle with area A x C, where A can be between 10 *µ*m and few centimeters and C can be between few hundreds of nm and 10 *µ*m. Similarly, the facet of a the unetched upper surface of the pillar and the miniaturized structure together, if approximated by a rectangle, may have an area of B x C, where B can be between few hundreds of nm and 20 *µ*m and C can be between few hundreds of nm and 10 *µ*m.

**The miniaturized structure is further characterized by a bottom profile.** The bottom profile lays on a plane parallel to the plane identified by the top surface.

The miniaturized structure is (partly) suspended above the bulk wafer and further characterized by at least one pillar connecting the bulk wafer (from which the miniaturized structure was obtained) and the bottom profile of the miniaturized structure.

The present disclosure relates to a system to micro- and nano-structure an anisotropic crystal obtaining a miniaturized structure like the one described above starting from a bulk wafer. The system and method presented in this disclosure enable effective and scalable fabrication of micro- and nano-structures in anisotropic crystals overcoming the costs of purchase and the implementation of a material stack including an anisotropic crystal thin-film.

The disclosed solution is useful for applications in photonics devices, for electro-optic devices, nonlinear optical devices, and acousto-optic devices implemented on a ferroelectric substrate. However, miniaturized structures obtained with the disclosed method could be functional also for electronics systems, acoustic sensors and actuators.

The system comprises a micro- or nano-fabrication system suited for implementing an anisotropic etching step (or similar step allowing directional material removal or ablation) on an anisotropic crystal thus defining the profile of the miniaturized structure, and of a second micro- or nano-fabrication system used for implementing a chemical etching step of the anisotropic material used to define the bottom profile of the miniaturized structure. Optionally the system may comprise also a tool to transfer the miniaturized structure from the bulk wafer where it was structured to a new substrate (e.g. a micro transfer printing system or a flip chip bonding tool).

The present disclosure further relates to a method for obtaining a miniaturized structure starting from a bulk wafer of an anisotropic material. The method comprises the following steps:
providing a bulk wafer of an anisotropic material, providing a tool (or a set of tools) to define via an anisotropic etching step (or similar directional material removal or ablation) the profile of the miniaturized structure, providing a tool to define via chemical etching the bottom profile of the miniaturized structure; implementing a lithographic mask followed by an anisotropic etching step, or alternatively ablating, cutting and, or dicing the anisotropic crystal so to define the profile of the miniaturized structure, implementing a chemical etching step so to define the bottom profile of the miniaturized structure.

Optionally, the steps above can be followed by other steps aiming at transferring the miniaturized structure from the bulk wafer where it was structured to a new substrate. Prior to the optional transfer, the miniaturized structure is (partly) suspended on the bulk wafer from which it has been obtained through at least one pillar, working as an anchor point between the bulk wafer and the bottom profile of the miniaturized structure.

With the presently disclosed solution, anisotropic crystal miniaturized structures can be implemented starting from bulk wafers of anisotropic crystals. By eliminating the need to handle and process expensive thin-film wafers, the method lowers the costs to obtain an anisotropic crystal miniaturized structure and permits to define flexibly all the dimensions (width, length and thickness) of micro- and nano-structures implemented on an anisotropic crystal. Furthermore, the disclosed approach can be applied to materials for which it is possible to fabricate high-quality bulk wafers but not possible to fabricate high-quality thin-film wafers or not possible to obtain micro- and nano-structures with a thickness compatible with traditional thin-film wafer configurations. Therefore, the information contained in this disclosure expands the micro- and nano-structuring possibilities of anisotropic crystals beyond what can be achieved in prior art.

According to a first aspect of the present disclosure, there is provided a system configured to provide a miniaturised structure from a bulk anisotropic material, the system comprising: a patterning apparatus configured to form, by way of patterning the bulk anisotropic material, a miniaturised structure in an upper surface of a bulk anisotropic material; a material removal apparatus configured to remove bulk anisotropic material around the miniaturised structure to form a pillar including the miniaturised structure on an upper surface thereof, wherein the pillar is laterally isolated from the surrounding bulk anisotropic material; and an etching apparatus configured to etch the pillar below the upper surface to reduce a perimeter of at least part of the pillar below the upper surface to thereby form a bottom profile beneath the upper surface, wherein the anisotropic properties of the bulk material result in anisotropic etching of the material of the pillar.

In one or more embodiments, the system may comprise a transfer apparatus, wherein the transport apparatus is configured to remove the miniaturised structure from the pillar. In one or more embodiments, the transfer apparatus may be further configured to mount the removed miniaturised structure to a substrate.

In one or more embodiments, the bulk anisotropic material may be a ferroelectric material.

In one or more embodiments, the material removal apparatus may be configured to implement one or more of:
an ion milling etching process;
a reactive ion beam etching process;
a reactive ion etching process;
another milling or etching process configured in a way to obtain directional material removal via an anisotropic etching process;
a dicing process, wherein the material removal apparatus comprises a dicing saw; and
a laser ablation process, wherein the material removal apparatus comprises a laser ablation tool.

In one or more embodiments, the etching apparatus may be configured to provide for anisotropic etching of the pillar along different crystallographic directions.

In one or more embodiments, the etching apparatus may be configured to leverage a chemical etching step and where the top surface of the microstructure and at least a portion of the pillar adjacent the upper surface of the pillar are protected by an etching mask whose geometry is chosen based on the etching rates along different crystallographic directions during the chemical etching step.

According to a second aspect of the present disclosure, there is provided a method for obtaining a miniaturised structure from a bulk anisotropic material, the method comprising: forming, by way of patterning the bulk anisotropic material, a miniaturised structure in an upper surface of a bulk anisotropic material; removing bulk anisotropic material around the miniaturised structure to form a pillar including the miniaturised structure on an upper surface thereof, wherein the pillar is laterally isolated from the surrounding bulk anisotropic material; etching the pillar below the upper surface to reduce a perimeter of at least part of the pillar below the upper surface to thereby form a bottom profile beneath the upper surface, wherein the anisotropic properties of the bulk material result in anisotropic etching of the material of the pillar.

In one or more embodiments, etching the pillar below the upper surface to reduce a perimeter of at least part of the pillar below the upper surface may comprise performing a chemical isotropic etching step which results in anisotropic etching of the material of the pillar due to the anisotropic properties of the bulk material.

According to a third aspect of the present disclosure, there is provided a miniaturized structure implemented on a bulk material obtained according to the method of the second aspect,

In one or more embodiments, the miniaturised structure may be configured to be used in a photonic device meant for use in electro-optic applications, nonlinear optical applications or acousto-optic applications and which could present further micro- and nano-fabricated elements implemented on its top surface.

In one or more embodiments, the miniaturised structure may comprise a high confinement optical structure. In one or more embodiments, the high confinement optical structure may be a waveguide.

### Description of the drawings

The present disclosure will in the following be described in greater detail with reference to the accompanying drawings. Various embodiments are described hereinafter with reference to the drawings. The drawings are examples of embodiments and are intended to illustrate some of the features of the presently disclosed solution, and are not limiting to the presently disclosed system and method.
Fig. 1 a schematic representation of smart-cut method, used in prior art to obtain thin-film wafers of anisotropic crystals.
Fig. 2 a schematic representation of prior art fabrication process of micro- and nano-structures starting from a commercially available thin-film wafer.
Fig. 3 a schematic representation of prior art micro- and nano-structures (implemented according, for example, to a process like the ones Fig. 2) obtained starting from a commercially available thin-film wafer (implemented according, for example, to a process like the one in Fig. 1) transferred to a new substrate.
Fig. 4 a schematic representation of the main fabrication steps according to the process disclosed in this document.
Fig. 5 a schematic representation of an alternative set of fabrication steps to implement the process disclosed in this document.
Fig. 6 a view of the miniaturized structure suspended on top of the bulk material.
Fig. 7a a schematic representation of wet etching process of an anisotropic material.
Fig. 7b a schematic representation of wet etching process of an isotropic material.
Fig. 8 a schematic representation of wet etching process of an anisotropic material accounting for lack of inversion symmetry in the material crystallographic structure.
Fig. 9 a schematic representation of a miniaturized structures obtained according to the presently disclosed method transferred to a new substrate.
Fig. 10 a simulation of optical mode in miniaturized structure obtained according to the presently disclosed method.

### Detailed description of the invention

Anisotropic materials are materials characterized by physical properties depending on the direction along which they are measured. The response of an anisotropic material to an external stimulus changes depending on the direction from which such stimulus is applied. In the case of an anisotropic crystal the crystallographic axes can be used as preferred coordinate system to identify preferential directions along which the response of to a stimulus changes. When micro- and nano-structuring an anisotropic crystal, the anisotropy in the response to external stimuli is apparent. To correctly micro- and nano-structure an anisotropic crystal it is therefore imperative to know the crystallographic orientation of the anisotropic material sample to be structured and correctly choose its orientation during processing.

In micro- and nano-fabrication processes, regardless of the isotropy of the material on which the process is being performed, it is possible to define the isotropy of the process itself. Within this disclosure an isotropic process is a process which, when applied to an isotropic material affects the material in the same way along all directions. For example, wet etching in hydrofluoric acid solution is considered an isotropic process. Indeed, **wet etching** in hydrofluoric acid solution of an **anisotropic crystal** typically shows **different etching rates along different crystal** axes, whereas wet etching in hydrofluoric acid solution of a sample made of an **isotropic material** (e.g. silicon dioxide) **gives the same result along all directions.** The particular property that imparts the anisotropic etching rates is, for the present purposes, unimportant. The key is that one or more properties of the material in question result in an anisotropic etching behaviour when exposed to an isotropic etch.

Similarly, **ion milling** or focused ion beam milling are considered anisotropic processes, with a preferential direction set by the direction along which the ions are accelerated. Indeed, ion milling an **isotropic** sample gives qualitatively the same result as ion milling an **anisotropic** sample: **both samples are almost solely thinned along the direction of ion bombing and nearly unetched in the perpendicular directions.**

A preferred embodiment of the present disclosure relates to a system for micro- and nano-structuring an anisotropic crystal or other anisotropic material. It will be appreciated that references to anisotropic crystals may also refer to other anisotropic materials. The system may comprise a tool (or a set of tools) suited for micro- and nano-structure in-plane the anisotropic material by etching, ablating or otherwise removing material in a controlled way and along one direction, defining the profile of the miniaturized structure; the system further comprises a second tool (or set of tools) suited for micro- and nano-structure the anisotropic material by performing a chemical etching step which etches the anisotropic material preferentially along specific crystallographic directions and allows to define the bottom profile of the miniaturized structure. The system might optionally comprise also a third tool (or set of tools) suited for transferring the miniaturized structure obtained on the anisotropic crystal bulk material to a new substrate. The transfer apparatus that provides for transfer of the miniaturised structure from the bulk may be configured to at least remove the miniaturised structure from the pillar to which is it coupled. The transfer apparatus may further be configured to move the miniaturised structure to a second substrate different to the first substrate. The transfer apparatus may also be configured to mount the removed miniaturised structure to a substrate. In other embodiments, the transfer apparatus may be configured to flip the body where the miniaturised structure lies and bond the miniaturised structure to a new substrate prior to separating it from the anisotropic bulk material.

The tool or set of tools for removing material by way of an anisotropic technique may be referred to as a material removal apparatus or an anisotropic material removal apparatus. The material removal apparatus may be configured to remove bulk anisotropic material around a miniaturised structure to form a pillar that includes a miniaturised structure on an upper surface thereof such that the pillar is laterally isolated from the surrounding bulk anisotropic material. For example, the material removal apparatus may be configured to remove bulk material in order to form a trench-like structure or moat-like structure around a miniaturised structure that has been patterned onto the surface of the bulk material. This material removal apparatus may, thereby, leave the miniaturised structure and, optionally, some bulk material bordering the miniaturised structure, laterally isolated from the remainder of the bulk material. In such an example, the miniaturised structure may still be coupled to the remainder of the bulk material by way of the pillar which supports it, but a contiguous path from the miniaturised structure to the laterally spaced bulk material would need to be traced via the trench.

The tool or set of tools configured to provide for chemical etching the pillar below the upper surface to reduce a perimeter of at least part of the pillar below the upper surface may be referred to as an etching apparatus. The etching apparatus may be configured to implement a chemical isotropic etching process such that the miniaturised structure and, optionally, bulk material bordering the miniaturised structure is not etched while the pillar which connects the miniaturised structure to the rest of the bulk material is etched. Despite the etching apparatus being configured to implement an isotropic etch, the anisotropic properties of the bulk material may be such that the pillar is etched in an anisotropic manner.

Any suitable approach may be taken in order to avoid the etching of the miniaturised structure and, instead, etching the pillar below the upper surface. For example, one or more masks may be applied to the miniaturised structure in order to ensure that the miniaturised structure is not etched. In such embodiments, the system may comprise a masking apparatus configured to apply a mask to at least the miniaturised structure. In other examples, an etching fluid (gas or liquid) may be applied and maintained below the level of upper surface such that the pillar is etched without etching of the upper surface.

The apparatus may further comprise a patterning apparatus configured to form, by way of patterning the bulk anisotropic material, a miniaturised structure in an upper surface of the bulk anisotropic material. The patterning apparatus may be configured to perform patterning in any way that is suitable for patterning a miniaturised structure. The patterning apparatus may be the same as, or share common elements with, one or more of the material removal apparatus and the etching apparatus.

In other examples, the system may be configured to receive a pre-patterned anisotropic material and start its process by using the material removal apparatus to form a pillar and subsequently use the etching apparatus to etch the pillar below the upper surface to reduce a perimeter of at least part of the pillar below the upper surface.

In some embodiments, the anisotropic crystal is transparent at visible wavelengths. In some embodiments, the anisotropic crystal is transparent at wavelengths between 800nm and 2000nm. In some embodiments, the anisotropic crystal is transparent at wavelengths between 250nm and 5000nm.

In some embodiments, the anisotropic material is piezoelectric. In some embodiments, the anisotropic material is a ferroelectric. In some embodiments, the anisotropic material is a periodically poled ferroelectric crystal.

In some embodiments, the system comprises a lithography tool used to define an etching mask above an anisotropic crystal. In some embodiments, the etching mask is meant to protect the top of the miniaturized structure during an anisotropic etching step. In some embodiments, the etching mask is meant to protect the top, the sidewalls and the facts of the miniaturized structure during an etching step.

In some embodiments, an anisotropic etching step is used to remove in a controlled way the material not protected by the etching mask so to define the profile of a miniaturized structure sitting on top of the bulk anisotropic crystal.

In some embodiments, the anisotropic etching step is performed using an ion milling process, where Ar+, N+ or other charged species suited for ion milling processes are accelerated towards the anisotropic crystal.

In some embodiments, by ion milling the surface, the areas of anisotropic material which are not protected by an etching mask are removed via physical etching with a precise control of the etching depth.

In some embodiments, an anisotropic etching step is performed using a reactive ion etching process, carefully choosing the process parameters to obtain an anisotropic physical and chemical etching process so to define the profile of a miniaturized structure sitting on top of the bulk anisotropic crystal.

In some embodiments, an anisotropic etching step is performed using a reactive ion etching process, carefully choosing the process parameters to obtain an anisotropic physical and chemical etching process permitting to controllably etch the anisotropic crystal down to a known etching depth.

In some embodiments, the etching depth is chosen to be between 10nm and 100um.

In some embodiments, laser ablation is used to selectively remove in a controlled way material from the top surface of an anisotropic crystal sample with a known ablation depth.

In some embodiments the ablation depth is chosen to be between 500nm and 100um.

In some embodiments, a dicing tool is used to selectively remove in a controlled way material from the top surface of an anisotropic crystal sample operating the blade in such a way to control the cutting depth.

In some embodiments, the cutting depth is chosen to be between 1um and 100um.

In some embodiments, a hard mask covering the top profile of the miniaturized structure is implemented on the surface of an anisotropic crystal.

In some embodiments, the hard mask is used as a protective mask during other processing steps.

In some embodiments, the hard mask is defined in a way to protect the top, the sidewalls as well as the facets of the miniaturized structure during subsequent processing steps.

In some embodiments, the hard mask is metallic and has a thickness between 10 nm and 10 um.

In some embodiments, the hard mask is Chromium.

In some embodiments, the hard mask covers conformally the miniaturized structure defined by the anisotropic etching, dicing or laser ablation step.

In some embodiments, the hard mask covers conformally the top and three quarters of the sidewalls and facets of the miniaturized structure defined by the anisotropic etching, dicing or laser ablation step, but leaves uncovered the bottom most quarter of the sidewalls and facets, where these meet the flat surface of the bulk wafer prior to performing a chemical etching step.

In some embodiments, the hard mask is obtained with a chemical vapour deposition method.

In some embodiments, a photoresist acts as hard mask.

In some embodiments the hard mask acts as an etch mask during a chemical etching process.

In some embodiments, the etch mask is not defined symmetrically with respect to the miniaturized structure.

In some embodiments, a ratio between 51/100 and 99/100 of the etch mask lies on one side with respect to the centre of the miniaturized structure.

In some embodiments, the exact positioning and shape of the etch mask depends on the anisotropic crystal response to a chemical etching process.

In some embodiments, during an isotropic etching process, the etching rate of the anisotropic material along a specific crystallographic axis (example: along axis "a") might differ from the etching rate along another crystallographic axis (example: along axis "b").

In some embodiments, during an isotropic etching process, the etching rate of the anisotropic material along a specific crystallographic axis (example: along axis "a") might differ depending on the etching direction, namely, the crystal facet perpendicular to +a might etch faster than the crystal facet perpendicular to -a.

In some embodiments, the material properties of the anisotropic crystal are locally engineered to engineer the material response to following processing steps.

In some embodiments, the material properties of the anisotropic crystal are locally engineered to control the etching rate of the anisotropic material along a particular axis.

In some embodiments, at an intermediate step of the fabrication process, the miniaturized structure is only partly defined and consists of ridge structures defined onto a monolithic sample of an anisotropic material bulk wafer on whose top surface the top surface and the profile of the miniaturized structure have been implemented but the bottom profile of the miniaturized structure has not been implemented yet.

In some embodiments, at an intermediate step of the fabrication process, the miniaturized structure is only partly defined and consists of ridge structures defined onto a monolithic sample of an anisotropic material bulk wafer on whose top surface the profile of the miniaturized structure has been cut out using a dicing tool.

In some embodiments, at an intermediate step of the fabrication process, the miniaturized structure is only partly defined and consists of ridge structures defined onto a monolithic sample of an anisotropic material bulk wafer on whose top surface the profile of the miniaturized structure has been obtained out using an etching process.

In some embodiments, at an intermediate step of the fabrication process, the miniaturized structure is only partly defined and consists of ridge structures defined onto a monolithic sample of an anisotropic material bulk wafer on whose top surface the profile of the miniaturized structure has been ablated using a laser system.

In some embodiments, the bottom profile of the miniaturized structure is defined by wet etching.

In some embodiments, the bottom profile of the miniaturized structure is defined by a reactive ion etching process whose parameters have been carefully selected to ensure that the process behaves in a highly isotropic way.

In some embodiments, the bottom profile of the miniaturized structure is defined by vapour etching.

In some embodiments, the bottom profile of the miniaturized structure is defined by a plasma-less, dry vapour, hydrofluoridric acid etching process.

In some embodiments, the chemical etching process is implemented using a mixture based on Hydrofluoric acid.

In some embodiments, the chemical etching process is implemented using a mixture of Hydrofluoric acid and HNO₃.

In some embodiments, the chemical etching process is implemented using a mixture of 6 parts Hydrofluoric acid (40% concentration) and 4 parts of HNO₃(100% concentration).

In some embodiments, the isotropic chemical etching step defining the bottom profile proceeds faster along the direction parallel to the plane defined by the miniaturized structure top surface than in the direction perpendicular to the top surface of the miniaturized structure by virtue of the anisotropy of the material which is being etched.

In some embodiments, the isotropic chemical etching step defining the bottom profile of the miniaturized structure, proceeds at different speeds from the two sidewalls of the miniaturized structure by virtue of the anisotropy of the material which is being etched.

In some embodiments, the ratio between the etching rates from the two sidewalls in the chemical etching process defining the bottom profile is between 1.5 and 15.

In some embodiments, the isotropic chemical etching step defining the bottom profile of the miniaturized structure, proceeds at the same speed from both sidewalls of the miniaturized structure notwithstanding the anisotropy of the material which is being etched.

In some embodiments, the isotropic chemical etching step defining the bottom profile is optimized to ensure that it will proceeds at the same speed (or at only marginally different speeds) from both sidewalls of the miniaturized structure notwithstanding the anisotropy of the material which is being etched.

In some embodiments, the anisotropic material is engineered so to ensure that the isotropic chemical etching step defining the bottom profile proceeds at the same speed (or at only marginally different speeds) from both sidewalls of the miniaturized structure.

In some embodiments, the ratio between the maximum etching rate during the chemical etching step, happening along the direction parallel to the top of the miniaturized structure, is up to 100 times larger than the minimum etching rate, happening along the direction perpendicular to the top of the miniaturized structure.

In some embodiments, the miniaturized structure top width is between 100 nm and 20 *µ*m; the structure height is between 300 nm and 50 *µ*m (and accounts also for the at least one pillar keeping suspended the miniaturized structure on top of the bulk wafer); the structure thickness is between 100 nm and 30*µ*m.

In some embodiments the structured defined on a bulk anisotropic wafer according to the system and method presented in this disclosure is transferred from the bulk anisotropic wafer where it was implemented to a new substrate.

In some embodiments the anisotropic structured is transferred from the bulk anisotropic wafer where it was implemented to new substrate by transfer printing methods.

In some embodiments the anisotropic structured is transferred from the bulk anisotropic wafer where it was implemented to new substrate by flip chip bonding methods followed by a step to split the transferred structure from the bulk wafer.

In some embodiments the anisotropic structured transferred from the bulk anisotropic wafer where it was implemented to new substrate by flip chip bonding methods is polished by chemical and/or mechanical polishing methods prior to being transferred to a third substrate.

In some embodiments the anisotropic structured is not transferred and the etched anisotropic material is replaced with a lower refractive index material by material deposition, additive manufacturing methods or by spinning and curing a suited polymeric or colloidal solution.

In some embodiments the miniaturized structure can present a ridge waveguide or other microfabricated elements etched on its top surface.

In some embodiments the miniaturized structure can present a rib waveguide or other microfabricated elements etched on its top surface.

In some embodiments the miniaturized structure can present a waveguide integrated Bragg grating or other microfabricated elements etched on its top surface.

Another preferred embodiment relates to an anisotropic crystal micro- or nano-structure fabricated according to any one of the methods described in the present disclosure.

### Examples

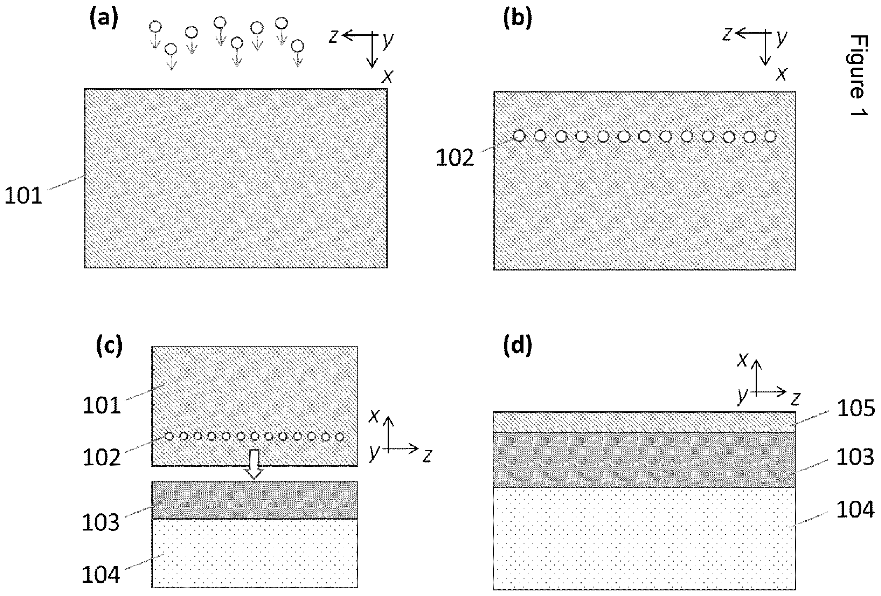

Fig. 1 shows a schematic view of prior art smart-cut method for implementing a thin-film wafer. With reference to Fig. 1(a), an anisotropic crystal (101) in a bulk form is implanted with He+ ions accelerated toward its top surface. In Fig. 1(b), the defect line created by the implanted He+ ions (102) is visible in the bulk material. In Fig. 1(c), the implanted anisotropic bulk wafer is flipped and bonded onto a second wafer characterized by a buffer layer (103) and a carrier layer (104). The stack is then split (thus removing the bulk part) to obtain a thin-film (105) on top of the buffer layer. The new wafer stack is then annealed to retrieve the monocrystalline state of the thin-film and its surface polished. The crystal axes of the anisotropic material are shown for all the process steps.

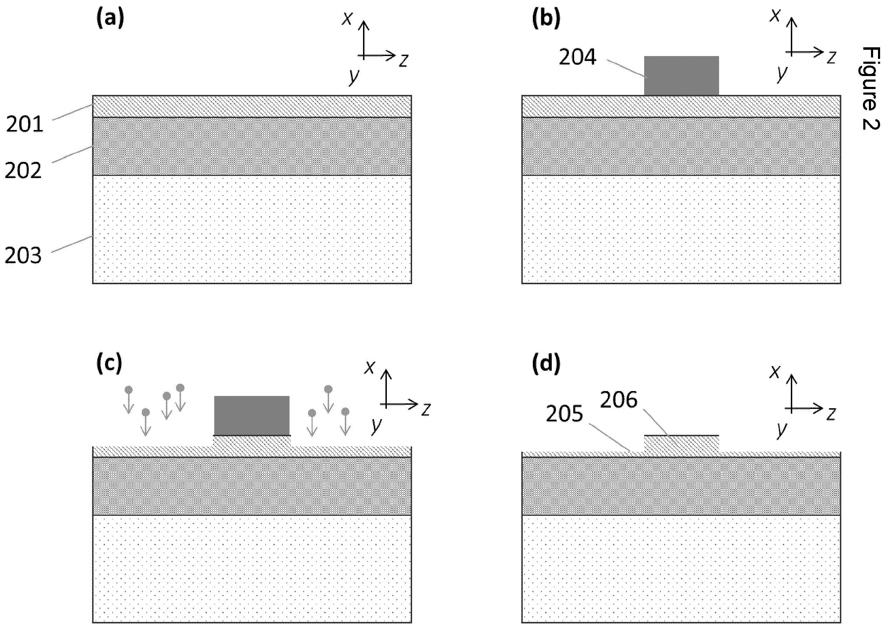

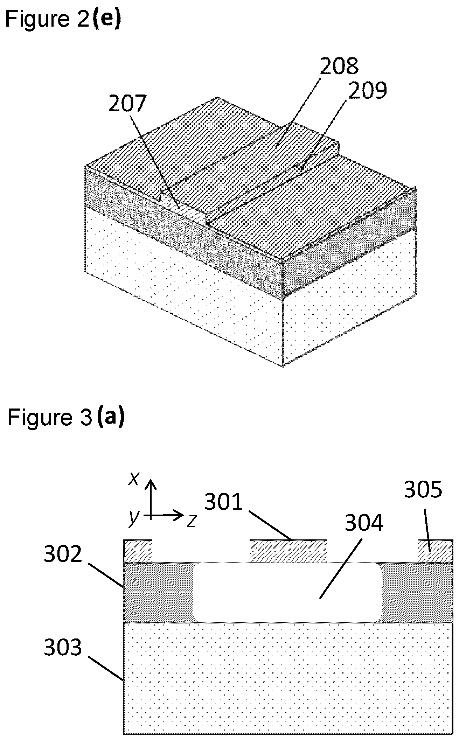

Fig. 2 shows a schematic view of prior art fabrication of a miniaturized structure starting from a commercially available thin-film wafer. With reference to Fig. 2(a), a commercially available thin-film wafer is characterized by: a carrier layer (203), a buffer layer (202) and the anisotropic material thin-film (201). In Fig. 2(b), an etching mask is implemented on top of the thin-film layer. In Fig. 2(c), the thin film is etched (for example utilizing an Ar+ ion milling process, an anisotropic process). In Fig. 2(d), a shallow slab (205) of unetched anisotropic thin-film is visible together with the cross section of the anisotropic micro-(nano-) structure (206). In Fig. 2(e) a 3D representation of the schematic of Fig. 2(d) is shown, highlighting the structure facet (207), the structure top (208) and the structure sidewall (209). The crystal axes of the anisotropic material are also shown.

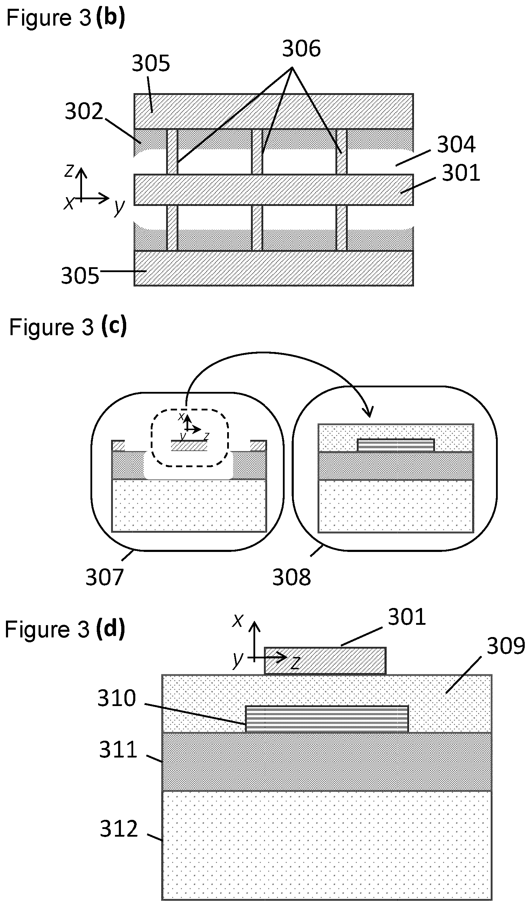

Fig. 3 shows a schematic view of prior art transfer of a nanostructure fabricated starting from a commercially available thin-film wafer to a new substrate. Fig. 3(a) shows a similar scenario to the one presented in Fig. 2(d), where a nanostructure fabricated on a commercially available thin-film wafer is visible. In Fig. 3(a) the buffer layer (302) has been underetched creating a void (304) below a suspended anisotropic nanostructure (301). The image also shows the carrier layer (303) and the anchor structures (305) used to keep in position the suspended nanostructure. Fig. 3(b) shows the top view of the component presented in Fig. 3(a), where the anchor bridges (306), providing structural stability to 301 are also visible. Fig. 3(c) shows the same structure visible in Fig. 3(a) and (b), highlighting that this can be considered a "source substrate" (307) from which the nanostructure (301) can be "picked and transferred" to a new substrate (308). The transferring can be implemented relying on different methods (e.g. transfer printing or flip chip bonding). The final result, after that the nanostructure (301) has been transferred, is visible in Fig. 3(d) where the new substrate is illustrated in detail: it is constituted of its own carrier layer (312), its own buffer layer (311), a top caldding (309), its own functional structure (310) which can be coupled to the transferred nanostructure (301) for example through a vias, in case of electric signals; through evanescent coupling, in case of photonic or RF signals; through magnetic coupling in case of magnetic devices. The crystal axes of the anisotropic material are also shown.

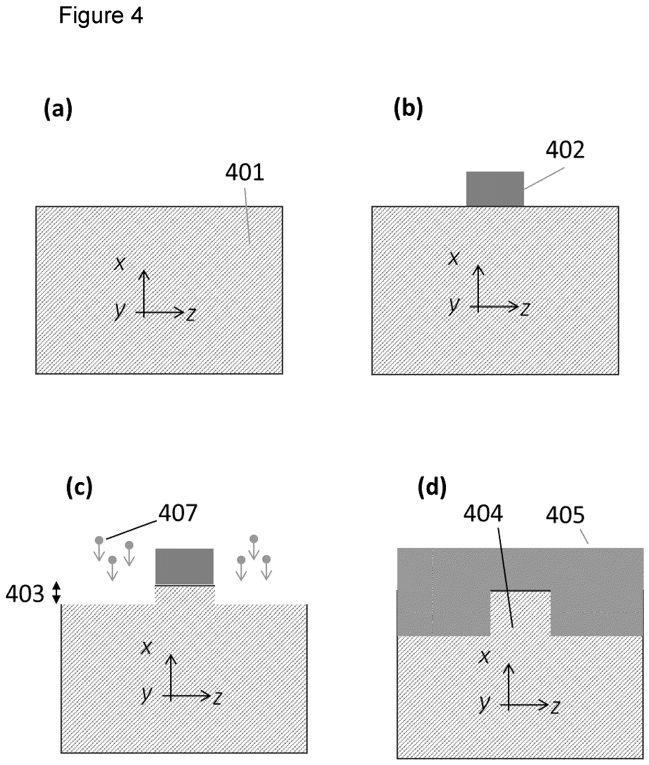

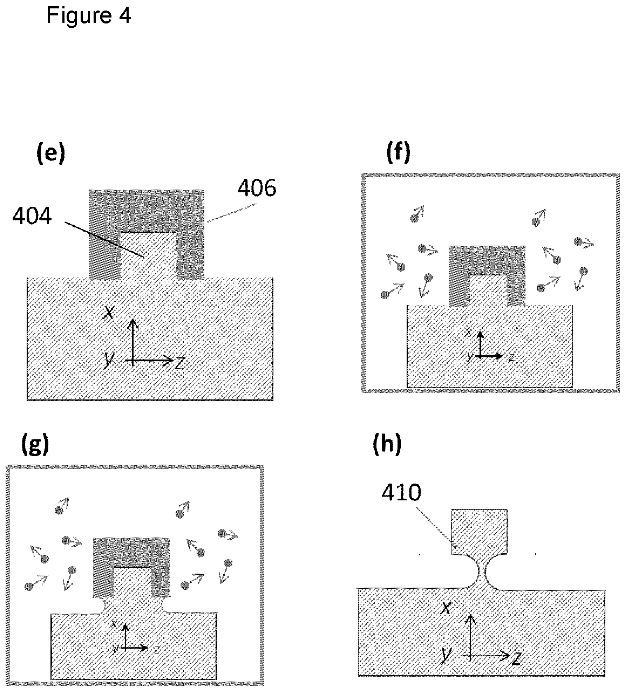

Fig 4. shows a schematic representation of a possible implementation of the fabrication steps proposed in this disclosure. In Fig. 4(a) an anisotropic crystal in bulk format (401) is visible. In Fig. 4(b) a mask (402), serving as protection layer for an anisotropic etching step, has been implemented on the crystal. In Fig. 4(c) an anisotropic etching (e.g. ion milling) step is being implemented on the crystal, implementing a structure (404) on top of it. The preferential direction of the process is highlighted by the ions bombarding the surface of the anisotropic crystal (407). This transfers the pattern of the mask into the anisotropic crystal, creating the miniaturized structure's profile. The etching depth (403) can be controlled by tuning the etching parameters. In Fig. 4(d) the etched crystal has been covered by a new layer that serves as mask for a subsequent isotropic etching step (405, isotropic etching mask layer). In Fig. 4(e) the isotropic etching mask layer (405) has been structured into an isotropic etching mask (406) which is covering in a conformal fashion (i.e. covering the top, the sidewalls and the facets) the anisotropic crystal structure (404). In Fig. 4(f) the structure presented in Fig. 4(e) is placed in a system for implementing an isotropic chemical etching step. In Fig. 4(g) the isotropic chemical underetching of the masked structure is presented. Fig. 4(h) highlights the final result where a suspended structure (410) implemented on top of the anisotropic bulk wafer is visible.

The crystal axes of the anisotropic material are also shown.

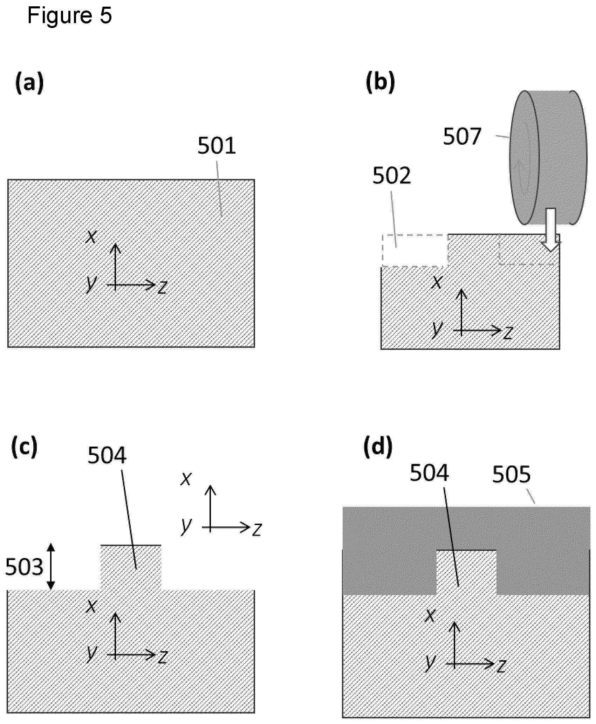

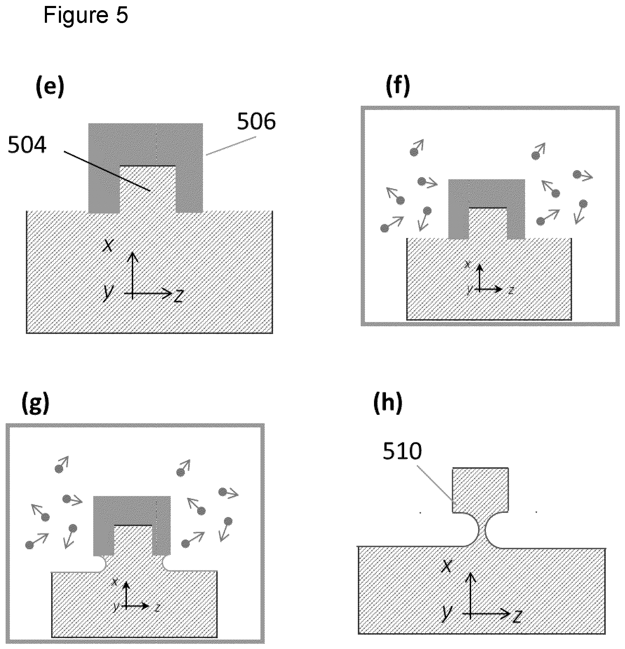

Fig 5. shows a schematic representation of a possible implementation of the fabrication steps proposed in this disclosure. In Fig. 5(a) an anisotropic crystal in bulk format (501) is visible. In Fig. 5(b) the profile of a micro- (nano-) structure (504) is defined on top of the bulk crystal by removing material (502) from the top surface with a dicing blade (507). In Fig. 5(c) the diced structure (504) is visible. The cutting depth (503) can be controlled by tuning the dicing system. In Fig. 5(d) the diced crystal has been covered by a new layer that serves as mask for a subsequent isotropic etching step (505, isotropic etching mask layer). In Fig. 5(e) the isotropic etching mask layer (505) has been structured into an isotropic etching mask (506) which is covering in a conformal fashion (i.e. covering the top, the sidewalls and the facets) the anisotropic crystal structure (504). In Fig. 5(f) the structure presented in Fig. 5(e) is placed in a system for implementing an isotropic chemical etching step. In Fig. 5(g) the isotropic chemical underetching of the masked structure is presented. Fig. 5(h) highlights the final result where a suspended structure (510) implemented on top of the anisotropic bulk wafer is visible.

The crystal axes of the anisotropic material are also shown.

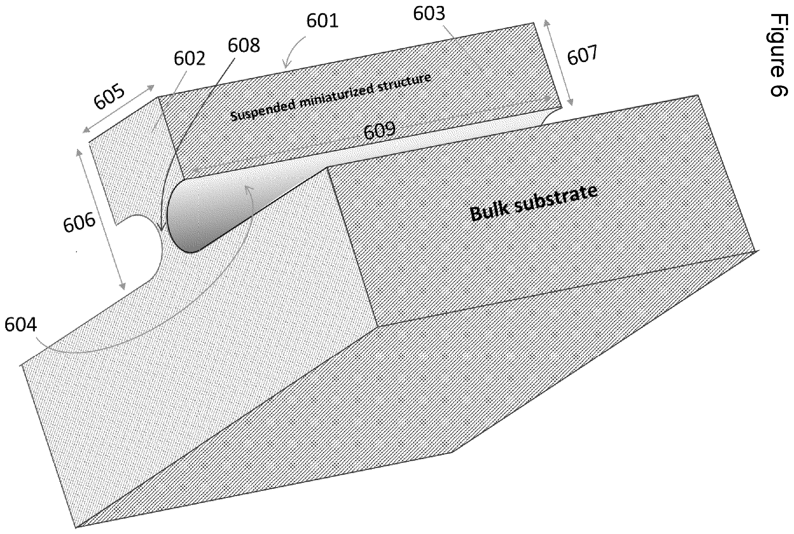

Fig. 6 shows an axonometric representation of a suspended miniaturized structure implemented according to a method like the ones presented in Fig. 4 or Fig. 5. The image highlights: the top width of the structure (605), the height of the structure (606), the thickness of the structure (607) as well as the top of the structure (601), a facet of the structure (602), a sidewall of the structure (603), a bottom profile (604) as well as a pillar (608) holding the suspended the miniaturized structure on top of the bulk wafers, substrate from which the miniaturized structure was obtained.

The length of the miniaturized structure (609) is also visible.

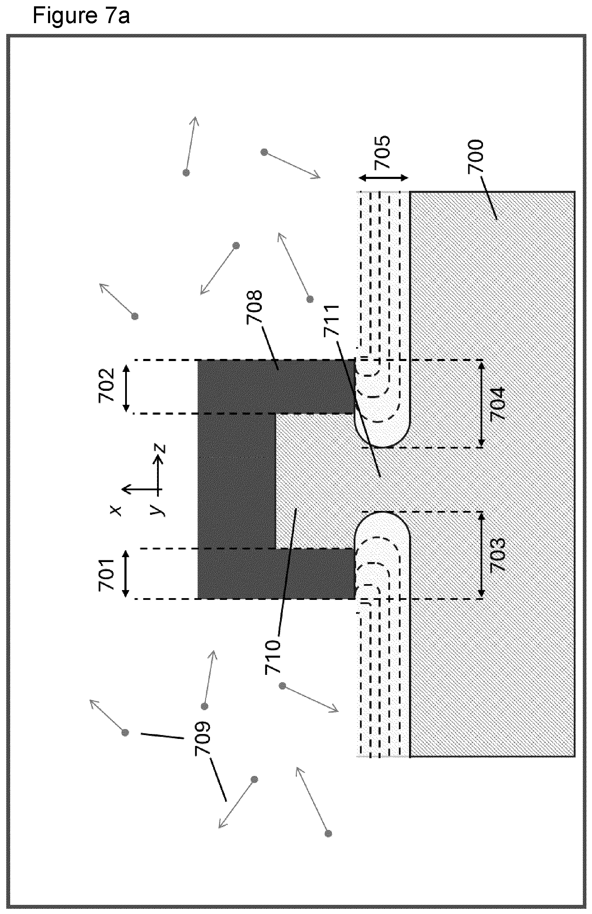

Fig. 7a shows a schematic representation of the chemical etching process. This etching process is (according to the nomenclature of this disclosure) isotropic, as highlighted by the multiple directions along which the particles responsible of the etching are moving (709). The etching mask (708) protects the top, the sidewalls (and the facets) of the structure. In this figure the left width of the isotropic etching mask (701) equals the right width of the isotropic etching mask (702). The thickness of the bulk anisotropic crystal (700) is reduced by a certain etching depth along the x-axis (705). Although the etching process is an isotropic process, the anisotropic nature of the crystal is apparent by comparing the etching depth along the x-axis (705) with the ones along the z-axis (on the left, 703 and on the right, 704). By carefully choosing the orientation of the anisotropic crystal orientation, it is possible to ensure that the left and the right etching depths along the z-axis (703, 704) are larger than the one along the x-axis (705), thus allowing to create (at least) a pillar (711) holding in position a suspended miniaturized structure (710).

The crystal axes of the anisotropic material are also shown.

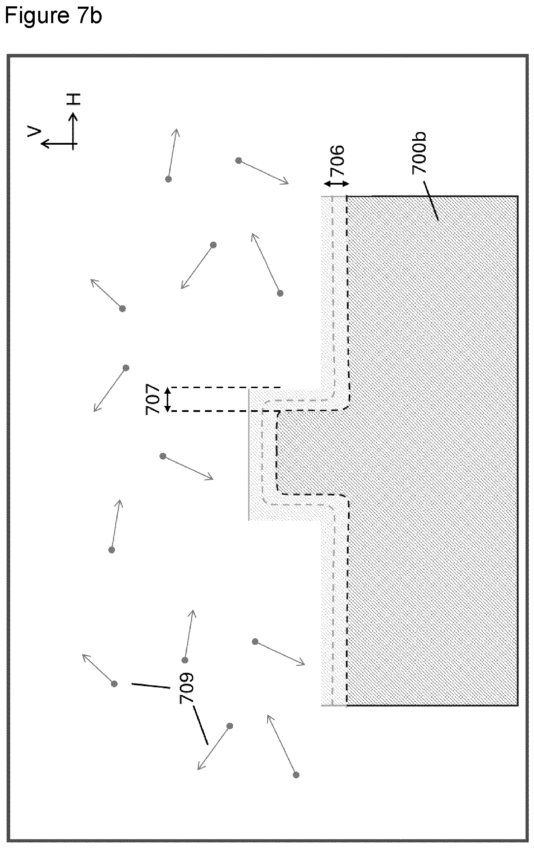

Fig. 7(b) shows a schematic representation of the chemical etching process. This etching process is (according to the nomenclature of this disclosure), isotropic, as highlighted by the multiple directions along which the particles responsible of the etching are moving (709). At variance with Fig. 7(a), in Fig. 7(b) the substrate being etched (700b) is isotropic and, as a consequence, the etching depth along vertical direction, V, (707) equals the one along the horizontal direction, H, (706). The axis shown in the image are an arbitrary reference frame indicating the horizontal and the vertical direction of the schematic.

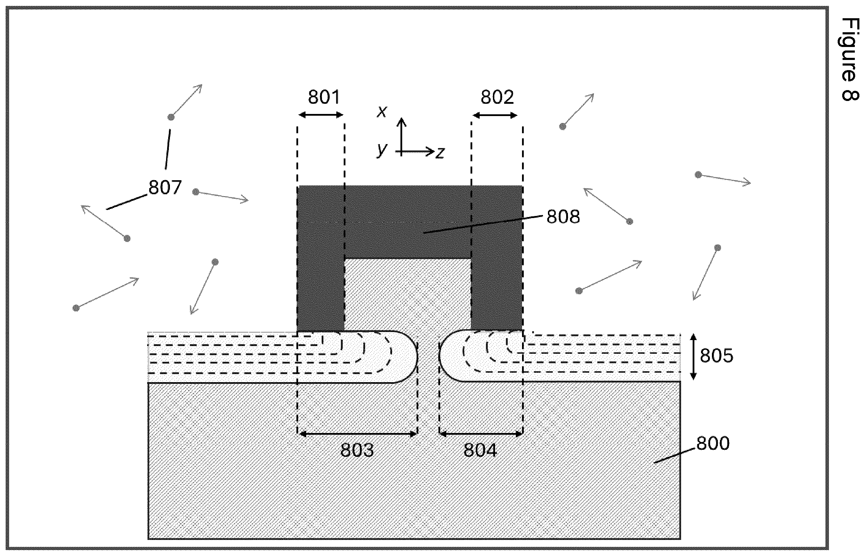

Fig. 8 shows a schematic representation of the chemical etching process. This etching process is (according to the nomenclature of this disclosure) isotropic, as highlighted by the multiple directions along which the particles responsible of the etching are moving (807). The isotropic etching mask (808) protects the top, the sidewalls (and the facets) of the structure. In this figure the left width of the isotropic etching mask (801) equals the right width of the isotropic etching mask (802). The thickness of the bulk anisotropic crystal (800) is reduced by a certain etching depth along the x-axis (805). Although the etching process is (according to the nomenclature of this disclosure) an isotropic process, the anisotropic nature of the crystal is visible by comparing the etching depth along the x-axis (805) with the ones along the z-axis (on the left, 803 and on the right, 804). Furthermore, the lack of symmetry of some anisotropic crystals manifests itself in different etching depth on the left and on the right side. In the represented case the left etching depth along z-axis (803) is approximately 1.5 times the right etching depth along the z-axis (804). This behaviour is visible in numerous ferroelectric crystals (for example in LiNbO3 where the different etching rates along the +z and the -z direction is used to make apparent periodically poled gratings). The difference between the left etching depth along z-axis and the right etching depth along z-axis can be tuned by carefully tuning the parameters of the process. Example of parameters that may be tuned are: position of the mask, local doping of the anisotropic bulk substrate being etched, concentration of reactants, temperature of the process, gas (vapour) pressure in case dry processes and so on. The crystal axes of the anisotropic material are also shown.

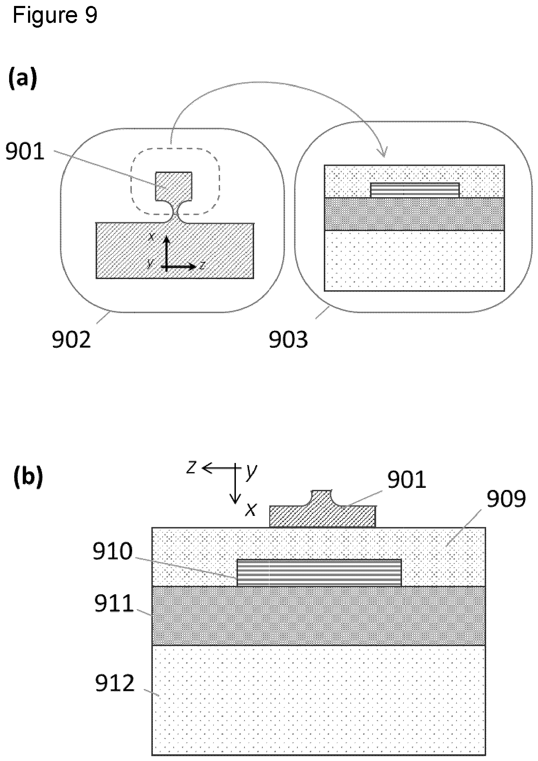

Fig. 9 shows a schematic representation of a micro- (nano-) structure (901) implemented according to a process disclosed in this document which is being transferred from the anisotropic bulk wafer (902) where has been fabricated to a new substrate (903). The fabricated structure is displayed rotated by 180° after the transfer, as would happen if the transfer were implemented by flip chip bonding. Other strategies (e.g. transfer printing) might be used to obtain similar results. The image also shows the details of the new substrate: the functional structure of the new substrate (910) as well as the buffer layer and the carrier layer of the new substrate (911 and 912, respectively).

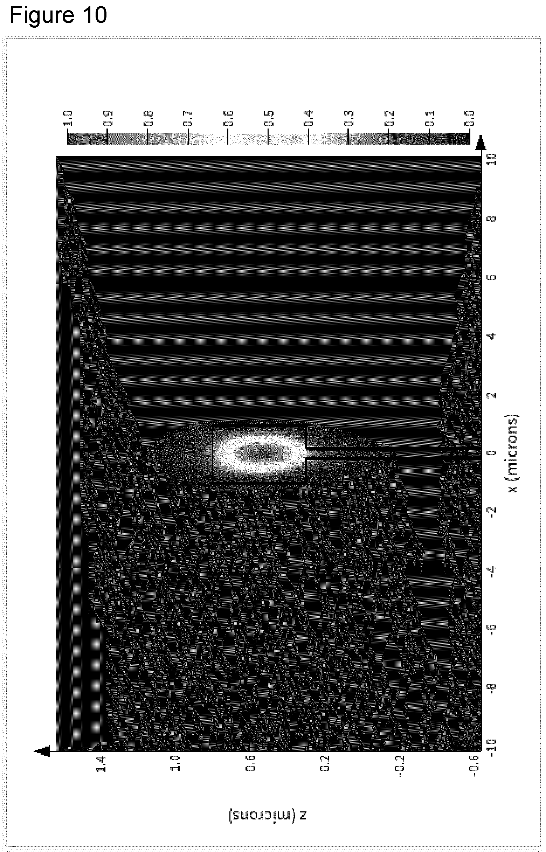

Fig. 10 shows a simulation of optical mode in a miniaturized structure obtained according to the presently disclosed method. The optical mode is confined to the miniaturized structure and its properties (in terms of mode shape and area and refractive index) are only marginally affected by the at least one pillar holding the miniaturized structure anchored to the bulk substrate.

### Further details of drawings

- 101 -: bulk anisotropic crystal
- 102 -: line defect created by implanted ions
- 103 -: buffer layer
- 104 -: carrier layer
- 105 -: anisotropic crystal thin-film
- 201 -: anisotropic crystal thin-film
- 202 -: buffer layer
- 203 -: carrier layer
- 204 -: etching mask
- 205 -: anisotropic crystal slab
- 206 -: anisotropic crystal structure
- 207 -: facet of anisotropic crystal structure
- 208 -: top of anisotropic crystal structure
- 209 -: sidewall of anisotropic crystal structure
- 301 -: anisotropic crystal suspended structure
- 302 -: buffer layer
- 303 -: carrier layer
- 304 -: etched void in the buffer layer
- 305 -: anchor structure
- 306 -: anchor bridges
- 307 -: source substrate
- 308 -: new substrate
- 309 -: top cladding
- 310 -: functional structure on the new substrate
- 311 -: buffer layer of the new substrate
- 312 -: carrier layer of the new substrate
- 401 -: bulk anisotropic crystal
- 402 -: anisotropic etching mask
- 403 -: etching depth
- 404 -: anisotropic miniaturized structure
- 405 -: isotropic etching mask layer
- 406 -: isotropic etching mask
- 407 -: ions responsible for the anisotropic etching and direction of their acceleration
- 410 -: anisotropic suspended structure
- 501 -: bulk anisotropic crystal
- 502 -: diced area on bulk anisotropic crystal
- 503 -: depth of the cut
- 504 -: anisotropic miniaturized structure
- 505 -: isotropic etching mask layer
- 506 -: isotropic etching mask
- 507 -: dicing blade
- 510 -: anisotropic suspended structure
- 601 -: top surface of the miniaturized structure
- 602 -: facet of the miniaturized structure
- 603 -: sidewall of the miniaturized structure
- 604 -: bottom profile of the miniaturized structure
- 605 -: miniaturized structure top width
- 606 -: miniaturized structure height
- 607 -: miniaturized structure thickness
- 608 -: pillar
- 609 -: miniaturized structure length
- 700 -: bulk anisotropic crystal
- 700b -: bulk isotropic crystal
- 701 -: left width of the isotropic etching mask
- 702 -: right width of the isotropic etching mask
- 703 -: left etching depth along z-axis
- 704 -: right etching depth along z-axis
- 705 -: etching depth along x-axis
- 706 -: etching depth in the vertical direction (V) for an isotropic material
- 707 -: etching depth in the horizontal direction (H) for an isotropic material
- 708 -: etching mask
- 709 -: etching directions in isotropic etching process
- 800 -: bulk anisotropic crystal
- 801 -: left width of the isotropic etching mask
- 802 -: right width of the isotropic etching mask
- 803 -: left etching depth along z-axis
- 804 -: right etching depth along z-axis
- 805 -: etching depth along x-axis
- 901 -: anisotropic crystal structure
- 902 -: source substrate
- 903 -: new substrate
- 909 -: top cladding
- 910 -: functional structure on the new substrate
- 911 -: buffer layer of the new substrate
- 912 -: carrier layer of the new substrate

### Items

1. A system for use in a process to implement a miniaturized structure on an anisotropic crystal for use in photonic applications. The system comprising:
   a tool (or a set of tools) to implement an anisotropic fabrication process, defining the sidewalls and the facets of the miniaturized structure. Sidewalls and facets, together, constitute the miniaturized structure's profile.
   a tool (or a set of tools) to etch, leveraging the anisotropy of the crystal, the bottom profile of the miniaturized structure and obtain a suspended miniaturized structure supported by at least one pillar on top of the anisotropic crystal.
   Optionally the system might also comprise a tool (or a set of tools) to transfer the miniaturized structure obtained according to this disclosure to a new substrate.
2. The system according to item 1 where the miniaturized structure is obtained on a ferroelectric material.
3. The system according to item 1 where the anisotropic fabrication process is implemented utilizing an ion milling etching process, a reactive ion beam etching process, a reactive ion etching process or another milling or etching process engineered in a way to obtain directional material removal via an anisotropic etching process.
4. The system according to item 1 where the anisotropic fabrication step is implemented utilizing a dicing saw to cut lines defining the sidewalls and the facets of the miniaturized structure.
5. The system according to item 1 where the anisotropic fabrication step is implemented utilizing a laser ablation tool, thus defining the facets and the sidewalls of the miniaturized structure.
6. The system according to item 1 where the definition of the miniaturized structure bottom profile is implemented leveraging a chemical etching step in combination with the anisotropic properties of the crystal to obtain a different etching ratio along different crystallographic directions.
7. The system according to item 1 where the definition of the miniaturized structure bottom profile is implemented leveraging a chemical etching step and where the top surface of the microstructure as well as at least a portion of the sidewalls and of the facets of the structures are protected by an etching mask whose geometry is chosen based on the etching rates along different crystallographic directions during the chemical etching step.
8. A method for implementing a miniaturized structure for use in photonic applications on an anisotropic crystal, the method comprising the steps of:
   ∘ providing an anisotropic crystal, a tool (or a set of tools) suited for implementing an anisotropic material removal step and a tool (or a set of tools) suited for implementing an isotropic chemical etching step,
   ∘ identifying an orientation of the anisotropic crystal allowing to leverage different etching rates obtainable along different crystallographic directions,
   ∘ implementing an anisotropic material removal step to define the sidewalls and the facets of the miniaturized structure,
   ∘ implement an etching mask covering the top, at least part of the sidewalls and at least part of the facets of the miniaturized structure,
   ∘ implementing an isotropic chemical etching step which permits to underetch the bottom profile of the miniaturized structure and to obtain a suspended miniaturized structure supported on top of the anisotropic bulk crystal by at least one pillar.
9. The method of item 8 where the isotropic chemical etching step leverages the anisotropy of the crystal (and/or engineered properties of the crystal) to obtain different etching rates along different crystallographic axes so to obtain a suspended miniaturized structure on top of the anisotropic bulk crystal.
10. A miniaturized structure implemented on a ferroelectric bulk sample obtained according to the method of item 8 and for use in a photonic device meant for use in electro-optic applications, nonlinear optical applications or acousto-optic applications and which could present further micro- and nano-fabricated elements implemented on its top surface.

## Claims

1. A system configured to provide a miniaturised structure from a bulk anisotropic material, the system comprising:
a patterning apparatus configured to form, by way of patterning the bulk anisotropic material, a miniaturised structure in an upper surface of a bulk anisotropic material;
a material removal apparatus configured to remove bulk anisotropic material around the miniaturised structure to form a pillar including the miniaturised structure on an upper surface thereof, wherein the upper surface of the pillar is laterally isolated from the surrounding bulk anisotropic material; and
an etching apparatus configured to etch the pillar below the upper surface to reduce a perimeter of at least part of the pillar below the upper surface to thereby form a bottom profile beneath the upper surface, wherein the anisotropic properties of the bulk material result in anisotropic etching of the material of the pillar.

2. The system according to claim 1 further comprising a transfer apparatus, wherein the transport apparatus is configured to remove the miniaturised structure from the pillar.

3. The system according to claim 2 wherein the transfer apparatus is further configured to mount the removed miniaturised structure to a substrate.

4. The system according to any preceding claim where the bulk anisotropic material is a ferroelectric material.

5. The system according to any preceding claim where the material removal apparatus is configured to implement one or more of:
an ion milling etching process;
a reactive ion beam etching process;
a reactive ion etching process;
another milling or etching process configured in a way to obtain directional material removal via an anisotropic etching process;
a dicing process, wherein the material removal apparatus comprises a dicing saw;
a laser ablation process, wherein the material removal apparatus comprises a laser ablation tool.

6. The system according to any preceding claim wherein the etching apparatus is configured to provide for anisotropic etching of the pillar along different crystallographic directions.

7. The system according to any preceding claim where the etching apparatus is configured to leveraging a chemical etching step and where the top surface of the microstructure and at least a portion of the pillar adjacent the upper surface of the pillar are protected by an etching mask whose geometry is chosen based on the etching rates along different crystallographic directions during the chemical etching step performed by the etching apparatus.

8. A method for obtaining a miniaturised structure from a bulk anisotropic material, the method comprising:
forming, by way of patterning the bulk anisotropic material, a miniaturised structure in an upper surface of a bulk anisotropic material;
removing bulk anisotropic material around the miniaturised structure to form a pillar including the miniaturised structure on an upper surface thereof, wherein the upper surface of the pillar is laterally isolated from the surrounding bulk anisotropic material;
etching the pillar below the upper surface to reduce a perimeter of at least part of the pillar below the upper surface to thereby form a bottom profile beneath the upper surface, wherein the anisotropic properties of the bulk material result in anisotropic etching of the material of the pillar.

9. The method of claim 8 wherein etching the pillar below the upper surface to reduce a perimeter of at least part of the pillar below the upper surface comprises performing a chemical isotropic etching step which results in anisotropic etching of the material of the pillar due to the anisotropic properties of the bulk material.

10. A miniaturized structure implemented on a bulk material obtained according to the method of any of claims 8 - 9,

11. The miniaturised structure of claim 10 configured to be used in a photonic device meant for use in electro-optic applications, nonlinear optical applications or acousto-optic applications and which could present further micro- and nano-fabricated elements implemented on its top surface.

12. The miniaturised structure of claim 11 wherein the miniaturised structure comprises a high confinement optical structure.
